# EUROPEAN PATENT APPLICATION

(11) **EP 4 648 214 A1**
(43) Date of publication of application: **12.11.2025**
(21) Application number: 24174520.7
(22) Date of filing: 07.05.2024
(51) Int. Cl.: H01P 5/107, H01L 23/66

(54) **LAUNCHER IN PACKAGE SEMICONDUCTOR DEVICE AND ASSEMBLY**

(71) Applicant: NXP B.V., 5656 AG Eindhoven (NL)
(72) Inventor: NANDAGOPAL, Harish, 5656AG Eindhoven (NL); SYED, Waqas Hassan, 5656AG Eindhoven (NL); VAN SCHELVEN, Ralph Matthijs, 5656AG Eindhoven (NL)
(74) Representative: Hardingham, Christopher Mark

(57) **Abstract**

Disclosed is a packaged semiconductor device, comprising: an MMIC device comprising a semiconductor die and having a differential IO; and a package substrate comprising dielectric between each of at least first through fourth metal layers, and electrically conductive vias between the metal layers; wherein the package substrate is connected to the MMIC device by a plurality of pillars between the MMIC device and the first metal layer, including a pair of the pillars which connect the differential IO to the first metal layer; wherein the first metal layer comprises a resonant slot opening therethrough between the pair of pillars; and wherein the second through fourth metal layers each comprise an opening therethrough, wherein the openings are configured to transition the IO signal between a differential mode and a waveguide fundamental mode of propagation at the fourth metal layer. A corresponding assembly further comprising a PCB is also disclosed.

## Description

### FIELD OF THE DISCLOSURE

The present disclosure relates to packaged millimetre or microwave frequency semiconductor devices.

### BACKGROUND

High performance millimetre-wave ("mm-wave") or microwave interfaces are important for maximizing the performance of monolithic microwave integrated circuits (MMICs). A cost-effective and performance-driven packaging technique to connect the MMIC's IOs to the external system, which is typically a printed circuit board (PCB) but could be another component such as a 3D antenna, can be realized by using a ball-grid-array based (BGA) package structure. Examples of these packages are embedded wafer level ball grid array (eWLB), flip-chip chip-scale package (FCCSP) and flip-chip ball-grid array (FCBGA).

A galvanic connection from the semiconductor die (MMIC) to the PCB board is then obtained, which normally includes two intermediate transitions: firstly, a die-to-package transition, which connects the die to the package substrate, and specifically connects the die to a metallization layer on top of a dielectric layer, which layers are typically part of a laminate metal-and-dielectric package substrate. A differential implementation of the semiconductor circuitry is generally preferred, as this decreases the sensitivity of the active circuitry to external (common-mode) signals present, for example, on the PCB lines. And so the transmission mode in both the die and the package will typically be differential as well. The second transition is at the package-to-PCB interface, which connects the package to the PCB using the (solder-ball) ball-grid array. In the case of so-called "launcher in package" devices, this interface can be designed to result in waveguide propagation modes of the millimetre-wave, or microwave, signals. Improving the overall transition from the differential transmission, based typically on strip-line, on the MMIC to the waveguide mode transmission in the PCB is of interest.

### SUMMARY

According to a fist aspect of the present disclosure, there is provided a packaged semiconductor device, comprising: a monolithic microwave integrated circuit, MMIC, device comprising a semiconductor die and having a differential IO being a one of a differential input and a differential output; and a package substrate comprising dielectric between each of at least a first metal layer (M1), a second metal layer (M2), a third metal layer (M3) and a fourth metal layer (M4), and electrically conductive vias between the metal layers; wherein the package substrate is connected to the MMIC device by a plurality of pillars between the semiconductor die and the first metal layer, the plurality of pillars including a pair of the pillars which connect the differential IO to the first metal layer; wherein the first metal layer comprises a resonant slot opening therethrough between the pair of pillars; wherein the second metal layer, third metal layer and the fourth metal layer each comprise an opening therethrough, wherein the resonant slot opening and the respective openings in the second, third and fourth metal layers are configured to transition the IO signal between the differential mode and a waveguide fundamental mode of propagation at the fourth metal layer. Such an arrangement may provide for a compact, and low loss transition from the die to the waveguide. Furthermore, the connection between the die and the waveguide may be relatively short compared with other configurations. Since long transmission lines may reduce the available bandwidth of the signal, embodiments of the present disclosure may also be beneficial in allowing for relatively wide bandwidth. Furthermore, in the case that the semiconductor die transmits and/or receives multiple millimetre or microwave signals, the length of the routing from die to launcher may be equal for different signals. Furthermore, by transitioning the signal directly to waveguide mode, the ohmic losses associated with galvanic paths, and in particular associated with signal transfer through pillars or solder balls, may be reduced or eliminated.

In one or more embodiments the resonant slot opening comprises a cross-bar of an H-shaped slot opening. An "H" configuration for a symmetrical or balanced resonant slot is particularly low loss.

In one or more embodiments the vias between each metal layer are arranged in a respective rectangle. This may assist in enabling the propagation of a fundamental waveguide mode. In one or more embodiments the fourth metal layer is a farthest metal layer of the package substrate from the MMIC device, and the opening therethrough is sized to match for transverse electric 10, TE10, waveguide propagation of the signal. In general, the T1 waveguide propagation mode is the most common and low loss propagation mode for a rectangular waveguide.

In one or more embodiments the opening through the second metal layer comprises a second resonant slot opening. In one or more such embodiments the second slot comprises a cross-bar of an H-shaped slot opening. The fourth metal layer may comprises a metal patch within the opening therethrough. In other embodiments, a patch in the fourth metal layer may not be required; this may result in an even more compact transition. Particularly for embodiments in which the fourth metal layer does not include a patch, the requirement for field matching may be partially met by suitable use of the electrically conductive vias between the metal layers.

In one or more embodiments the third metal layer is arranged between the second metal layer and the fourth metal layer, and has an opening therethrough having the same dimensions as the opening through the further layer.

In one or more embodiments the vias between each of the metal layers are aligned around a same perimeter of the opening through the fourth metal layer.

In one more embodiments the rectangle of vias between the first and second metal layers has a shorter side which is shorter than the corresponding shorter side of the rectangle of vias connecting between the second and third metal layer, and the shorter side of the rectangle of vias between the second and third metal layers is shorter than the corresponding shorter side of the rectangle of vias connecting between the third and fourth metal layers. In one or more such embodiments the second metal layer has a rectangular opening therethrough. In one or more such embodiments the rectangular opening through the second metal layer is smaller than the opening through the third metal layer.

In one or more embodiments the MMIC device further comprises encapsulant which at least partially encapsulates the semiconductor die, and the differential IO comprises contact pads on the semiconductor die.

In one or more embodiments the MMIC device further comprises a fanout laminate, on which the semiconductor die is mounted and which is configured to provide a fanout contact pattern, and the differential IO comprises pads on the fanout laminate, which pads are more spaced apart than corresponding contact pads on the semiconductor die, and connected thereto by a pair of strip lines configured to carry a signal in the differential mode to the differential IO. Use of a fanout laminate as part of the MMIC device may enable the packaged semiconductor device to include a semiconductor die having more compact arrays of die contacts, even where the pitch of the array is smaller than would be possible or allowed for design rules for bump bonding or flip chip bonding to the package substrate.

In one or more embodiments the packaged semiconductor device is a ball grid array, BGA, packaged semiconductor device. In one or embodiments the pair of pillars are aligned between a pair of ground pillars.

According to a second aspect of the present disclosure, there is provided an assembly comprising a packaged semiconductor device as described above; and a printed circuit board, PCB, on which the packaged semiconductor device is mounted, comprising an opening therein.

In one or more embodiments the opening in the PCB is rectangular, and arranged with the first, second and further metal layers such that the signal propagates through the PCB in a TE10 waveguide mode. In one or more other embodiments, the signal propagates through the PCB in a circular waveguide mode sch as a TE11 mode.

In one or embodiments the packaged semiconductor device is a ball grid array device, having a ball grid having gap therein arranged for propagation of the signal.

### BRIEF DESCRIPTION OF THE DRAWINGS

Reference will now be made to the accompanying drawings, which are not necessarily drawn to scale, and wherein:
FIG. 1 illustrates, schematically, a cross-section through a conventional packaged semiconductor device assembly;
FIG. 2. illustrates, schematically, a cross-section through a packaged semiconductor device assembly having integrated launchers;
FIG. 3. illustrates, schematically, a cross-section through a packaged semiconductor device assembly, according to embodiments of the present disclosure;
FIG. 4. illustrates, schematically, a cross-section through a packaged semiconductor device, according to embodiments of the present disclosure, in more detail;
FIG. 5 shows an assembly comprising a packaged semiconductor mounted on a support according to one or more embodiments;
FIG. 6 shows the layers, openings and vias of embodiments in more detail.
FIG. 7 shows an exploded view of the openings in the metal layers;
FIG. 8 shows an assembly comprising a packaged semiconductor mounted on a support according to one or more other embodiments;
FIG. 9 shows the layers, openings and vias of embodiments in more detail;
FIG. 10 shows an exploded view of the openings in the metal layers;
FIG 11 shows an assembly comprising a packaged semiconductor mounted on a support according to one or more further embodiments;
FIG. 12 shows the layers, openings and vias of embodiments in more detail;
FIG. 13 shows an exploded view of the openings in the metal layers;
FIG. 14 illustrates, schematically, a cross-section through a packaged semiconductor device, according to yet further embodiments of the present disclosure, in more detail, and
FIG. 15, shows, schematically, an alternative configuration of a resonance lot.

It should be noted that the igures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION

The subject disclosure describes, among other things, illustrative embodiments for effective signal propagation to and from packaged MMIC devices, using so-call "launcher-in-package" techniques.

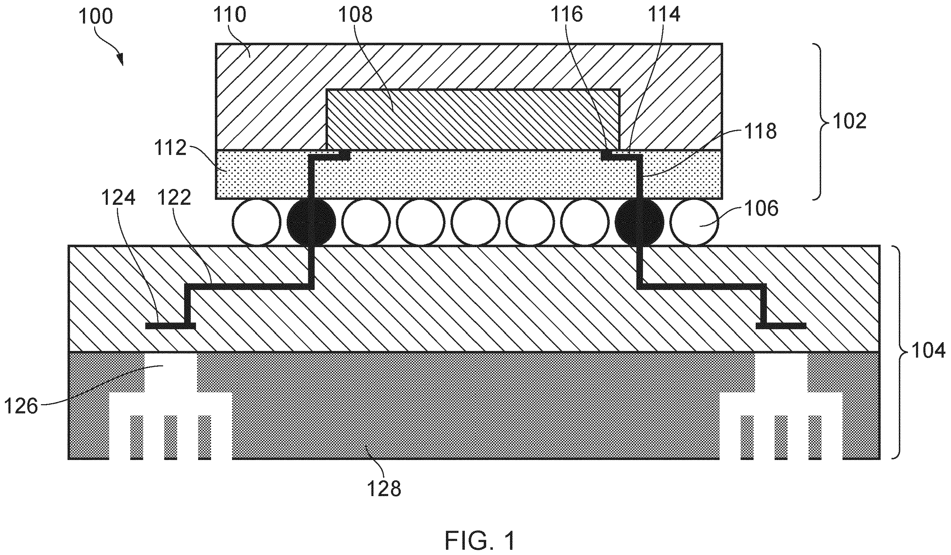

FIG. 1 illustrates, schematically, a cross-section through a conventional packaged semiconductor device assembly 100. The assembly comprises a packaged semiconductor device 102, which is mounted on a PCB 104 by means of a ball grid array comprising electrically conductive connectors or balls 106. Monolithic millimetre or microwave integrated circuit 108 is at least partially embedded or encapsulated in a mold compound or encapsulant 110. The MMIC is mounted on a substrate 112 which may be, for example, a multilayer laminated substrate, comprising a plurality of patterned electrically conductive layers such as metal layers, separated by electrically nonconductive material such as dielectric material, and connected by at least partially filled vias therebetween. The substrate 112 may include embedded electrically conductive tracks 114 formed within the electrically conductive layers, which may form part of a redistribution layer (RDL) in order to spread out the signals from, or to, the MMIC. The high frequency signals, that is to say typically millimetre-wave or microwave signals, which will hereinbelow be referred to simply as signals, are galvanically transferred from the MMIC and in particular from contact pads 116 on the MMIC across the package substrate, to the individual balls 106 of the ball grid array. The signals are transferred from the MMIC to the substrate and along the tracks 114 and associated vias 118. This may be achieved by any one of a variety of known techniques such as embedded wafer level ball grid array (eWLB), flip-chip chip-scale package (FCCSP) and flip-chip ball-grid array (FCBGA). It will be appreciated that some of these techniques include a further ball grid array (not shown in FIG. 1) which is independent of the ball grid array comprising the plurality of balls 106. The skilled person will be familiar that each signal may be transmitted using a pair of neighboring or nearly-adjacent tracks in the form of a differential signal, or may be transmitted along a single track in the form of a single-ended signal.

The or each signal is transferred to (in the case of the transmitted signal) or from (in the case of a received signal) the PCB via one, or a pair, of the balls 106 forming part of the ball grid array. As shown in FIG. 1 the signals are further routed within the PCB along conductive lines or tracks 122 such as metal strip lines towards (in the case of a transmitter) or from (in the case of a receiver) an antenna 124. The antenna 124 may take one of variety of forms such as patch antenna, slot antenna etc. The antenna acts to "launch" the signal such that thereafter it propagates in waveguide mode for instance through waveguides 126 in layer 128. Layer 128 of the PCB 104 may be referred to as an antenna layer, and the antenna may typically be a plastic metallized antenna, a metal milled antenna, or a SIW (substrate integrated waveguide) antenna. Hereinbelow, where appropriate in the context, the term "antenna" and "launcher" may be used interchangeably.

As will be apparent from FIG. 1, such an arrangement typically requires two propagation mode transitions - a first transition occurs as the signal is transferred from the MMIC to the substrate, and typically involves a transition from a fully differential propagation mode along for example a pair of strip lines, in the MMIC, to a single ended propagation mode along a single strip line, in the substrate. A second transition occurs at the launcher as the propagation is mode is changed to a waveguide mode which is typically a fundamental waveguide mode such as, in the case of rectangular waveguide, a TE10 (transverse-electric one-zero) mode.

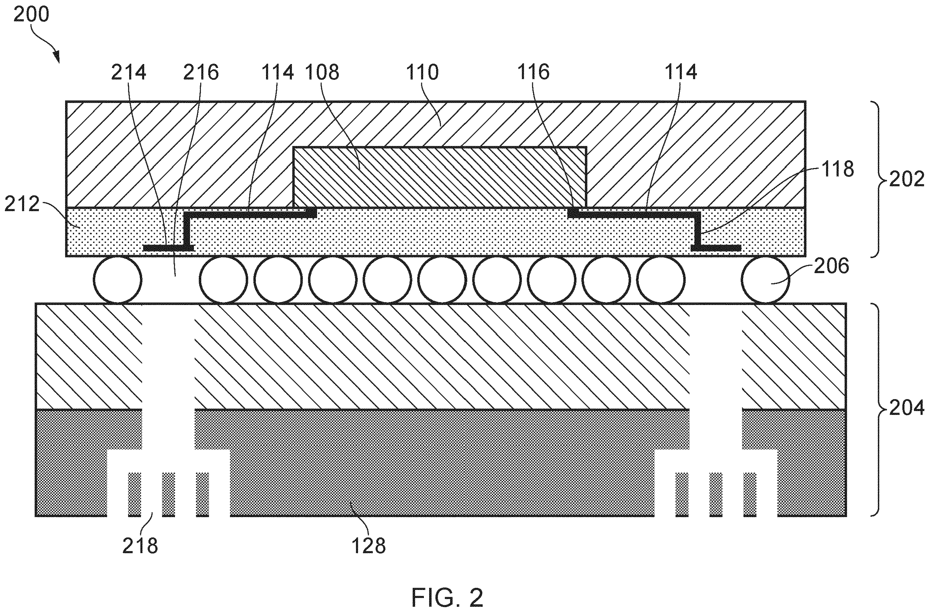

FIG. 2. illustrates, schematically, a cross-section through a packaged semiconductor device assembly 200 having integrated launchers, in which signals are transferred to or from a packaged semiconductor device 202 in a waveguide propagation mode. The assembly 200 comprises a packaged semiconductor device 202, which is mounted on a PCB 204 by means of a ball grid array comprising electrically conductive connectors or balls such as solder balls 206. The packaged semiconductor device 202 comprises a MMIC 108, encapsulant 110 and a substrate 212; MMIC 108 is at least partially embedded or encapsulated in the mold compound or encapsulant 110. MMIC 108 is mounted on the substrate 212 which may be, for example, a multilayer laminate substrate, comprising a plurality of patterned electrically conductive layers such as metal layers, separated by electrically nonconductive material such as dielectric material, and connected by at least partially filled, electrically conductive, vias therebetween. The substrate 212 includes embedded electrically conductive tracks 114 formed within the electrically conductive layers, which may form part of a redistribution layer (RDL) in order to spread out the signals from or to the MMIC. The high frequency signals are galvanically transferred from the MMIC and in particular from contact pads 116 on the MMIC 108 into the package substrate and along the tracks 114 and associated vias 118. In order to facilitate routing along the tracks 114 and through vias 118 which are typically laterally displaced from the contact pads 116 on the MMIC 108, the signals are typically transitioned from a differential strip line mode in the MMIC 108 to a single-ended strip line configuration of the track 114 in the substrate 212. A second mode transition occurs to waveguide propagation mode in, or more specifically at the surface of, the substrate 212, since a launcher 214 is positioned in or on the substrate 212. As above, the launcher 214 may be a slot, patch, or other suitable type of launcher with which the skilled person will be familiar.

The package semiconductor device is mounted on a support such as a PCB 204 by means of a ball grid array comprising a plurality of solder balls 206. In order for the signal to pass through the ball grid array and the PCB 204, the array of solder balls 206 includes a gap, or absence of solder balls, at a location beneath the launcher 214. Similarly, the PCB includes a hole or aperture 218 in order to allow waveguide propagation mode of the signal. The hole or aperture 216 may be lined with conductive material in order to provide a reflective surface, or may include electrically conductive vias (not shown) there-around, again as would be familiar to the skilled person.

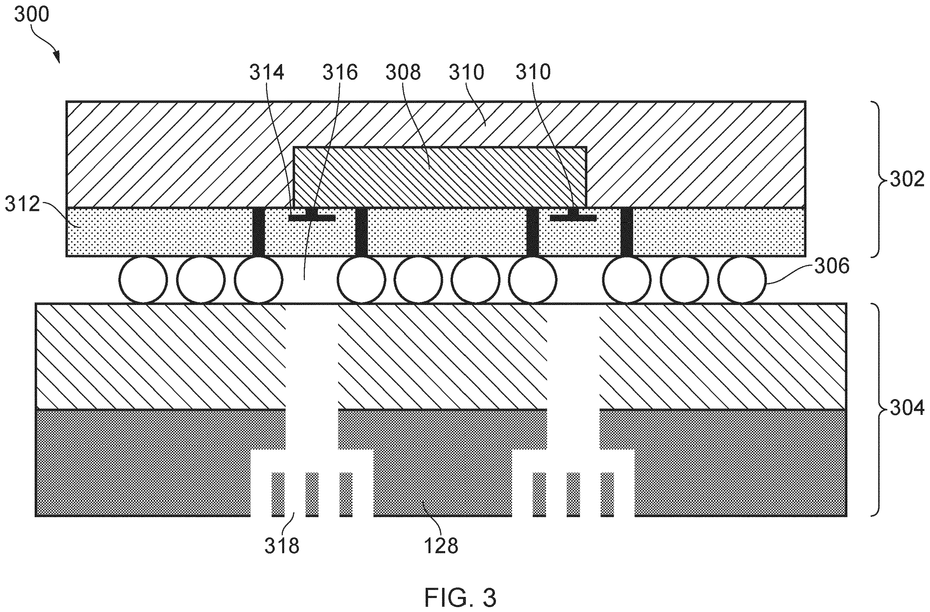

FIG. 3. illustrates, schematically, a cross-section through a packaged semiconductor device assembly 300, according to embodiments of the present disclosure. The assembly comprises a packaged semiconductor device 302 mounted on a support which may be a PCB 304, by means of a ball grid array of solder balls 306. The packaged semiconductor device 302 comprises a monolithic microwave integrated circuit, MMIC, device 308 comprising a semiconductor die and having a differential IO being a one of a differential input and a differential output 310; and a package substrate 312 comprising dielectric between metal layers (not shown). The packaged semiconductor device 302 is configured to transition the differential signal to, or directly to, a waveguide propagation mode, without the requirement or use of an intermediate redistribution layer, RDL having a single-ended signal transmission mode. Thus, as shown schematically, the signal is launched using a launcher 314 as it traverses package substrate 312. In order for the signal to pass through the ball grid array and the PCB 304, the array of solder balls 306 includes a gap, or absence of solder balls, at a location beneath the launcher 314. Similarly, the PCB includes a hole, opening or aperture 318 in order to allow waveguide propagation mode of the signal. The hole or aperture 316 may be lined with conductive material in order to provide a reflective surface, or may include electrically conductive vias (not shown) there-around, again as would be familiar to the skilled person. The hole or aperture 318 forming the waveguide through the PCB is aligned with the launcher 314 in the substrate 312 and thus may be directly below the contact pads (not shown) on the semiconductor die which forms the MMIC device 308.

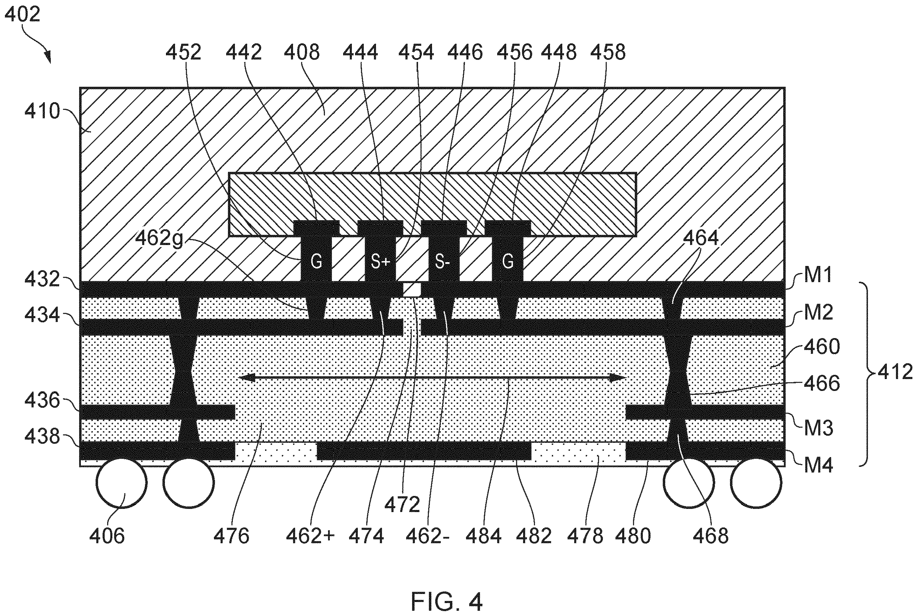

FIG. 4. illustrates, schematically, a cross-section through a packaged semiconductor device 402, according to embodiments of the present disclosure, in more detail. The figure shows a semiconductor die 408 which is at least partially encapsulated in encapsulant 410 and mounted on a substrate 412. The semiconductor die 408 includes a plurality of contact pads 442, 444, 446 and 448 thereon which are connected to a first metal layer M1 432 in the substrate 412, by means of pillars or bumps 452, 454, 456 and 458. The plurality of pillars or bumps 452 include a pair of the pillars 454, 456 which connect the differential IO at contact pads 444, 446 to the first metal layer, in order to transfer the signal S+ plus, S- to the substrate 412.

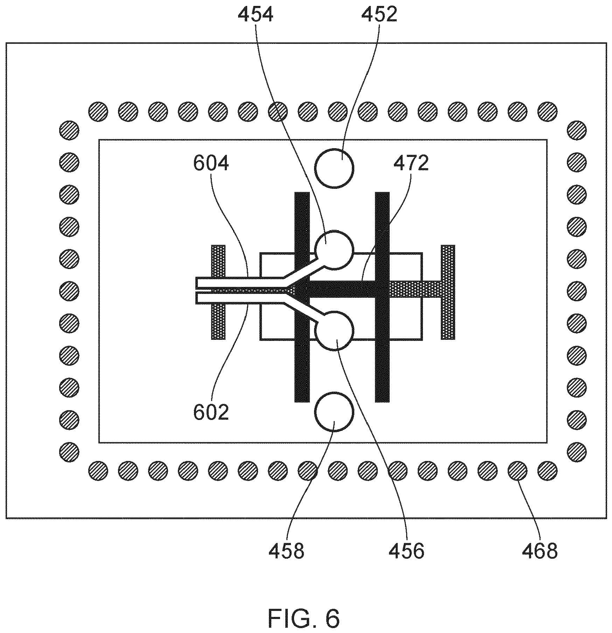

The package substrate 412 comprises dielectric 460 between each of at least the first metal layer M1 432, a second metal layer M2 434, a third metal layer M3 436 and a fourth metal layer M4 438, and electrically conductive vias 462, 464, 466 and 468 between the metal layers. The first metal layer comprises a resonant slot opening 472 therethrough between the pair of pillars 454, 456. The second metal layer M2 434 comprises an opening therethrough, which may be, as shown in FIG. 4, a further resonant slot 474. The third metal layer and the further metal layer comprise respective openings 476, 478 therethrough, which will be described in more detail hereinbelow with reference to FIG. 6.

The resonant slot opening in the first metal layer M1 434, the resonant slot opening in the second metal layer M2 434, and the respective openings in the third M3 and fourth M4 metal layers 436, 438 are configured to transition the IO signal between the differential mode and a fundamental waveguide propagation mode at the fourth metal layer M4 438. As part of this transition, when the IO signal reaches the finite resonant slots 47 in the first metal layer M1 434, it couples to a slot in its transition towards a waveguide mode. The fourth metal layer M4 438 may be at a lower surface of the substrate 412, although in other embodiments there may be a further layer, such as a protective non-conductive or dielectric layer 480, therebelow. As shown in FIG. 4, in one or more embodiments, the fourth metal layer M4 438 may include a patch or plate 482 within the opening 478 therethrough. The patch or plate 482 is electrically isolated from the remainder of the metal layer 438 outside the opening 478. The patch plate 482 may be described as a parasitic patch.

The size 484 of the openings 476, 478 in the metal layers M3 and M4 may be the same, as shown. The electrically conductive vias 468 between the metal layers M3 436 and M4 438, and the electrically conductive vias 466 between metal layers M2 432 and M3 436, may be vertically aligned. As will be shown more clearly in FIG. 6, they may surround the openings 478 and 476, in a rectangular or substantially rectangular arrangement. Similarly, the electrically conductive vias 462 between metal layers M1 432 and M2 434 may surround the opening 476 through metal layer M3 436, in a rectangular or substantially rectangular arrangement. In this context, "substantially rectangular" may refer to an arrangement of the vias which is rectangular but includes rounded corners. The vias may act as an electromagnetic shield or fence in order to improve the wave-guided characteristic of the signal as it transitions towards the waveguide mode which may be considered to be "launched" from the patch or plate 482 within the opening in the metal layer 438. As shown, the electrically conductive vias 462 between metal layer M1 432 and metal layer M2 434 include vias 462+ and 462- which are located directly below the pillars or bumps 454 and 456 for transferring the differential signal from the semiconductor die 408 to the metal layer M1 432. Furthermore, the electrically conductive vias 462 include vias 462g which are located directly below the pillars or bumps 452 and 458 for transferring a ground or earth from the semiconductor die 408 to the metal layer M1 432.

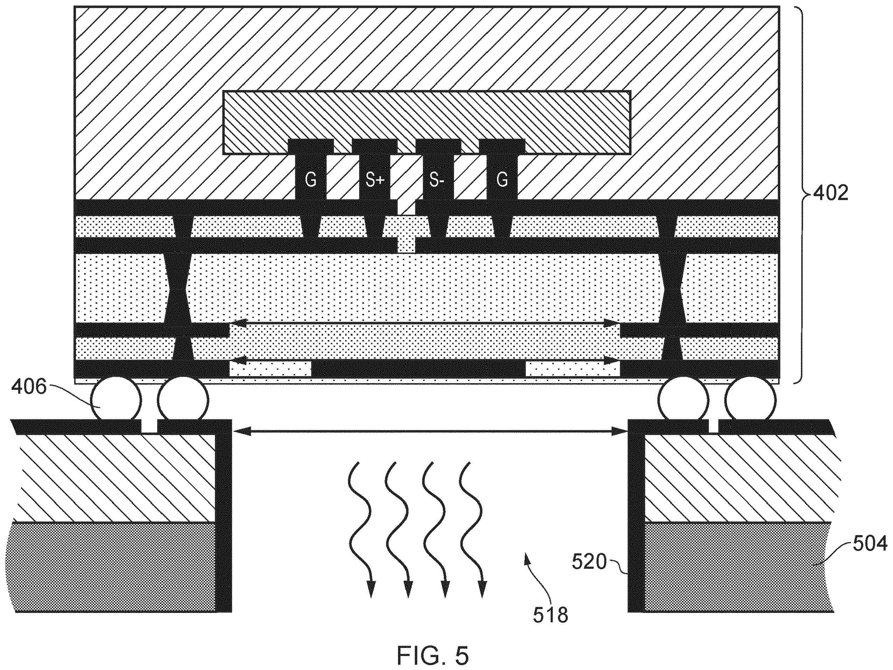

Turning now to FIG. 5, this shows an assembly comprising a packaged semiconductor such as that shown in FIG. 4 mounted on a support such as a printed circuit board PCB 504 according to one or more embodiments. The packaged semiconductor device is mounted on the PCB 504 by means of a ball grid array, being an array of solder balls 406 which includes therein a gap through which the signal propagates in a waveguide mode. The substrate also includes an aperture or hole 518 therethrough. The aperture or hole 518 through the substrate is appropriately dimensioned for waveguided transmission of the millimetre-wave or microwave signal. The waveguide transmission may be through a circular waveguide, or may typically be through a rectangular waveguide. In the case of a rectangular waveguide, for efficient low-loss propagation, the aperture and thus waveguide is dimensioned and sized for the fundamental transverse electric, that is to say TE10, waveguide propagation mode. The hole or aperture 518 through the PCB 504 which forms a waveguide may, as shown, include a conductive coating 520 on its perimeter in order to provide a reflective surface to assist in the waveguiding [.

It will be appreciated that although FIG. 4 and FIG. 5 show a semiconductor die having, in section, only the one signal path having a transition from a differential signal S+ and S- to a corresponding waveguide beneath the semiconductor die 408, the FIG. s are illustrative only, and in a practical implementation there may be several such signal paths including appropriate slots and openings in the metal layer within the substrate. Similarly, the positions of the transitions shown in FIG. 3 are illustrative only and are not limited to the perimeter of the semiconductor die which, in this embodiment, forms the MMIC device 308.

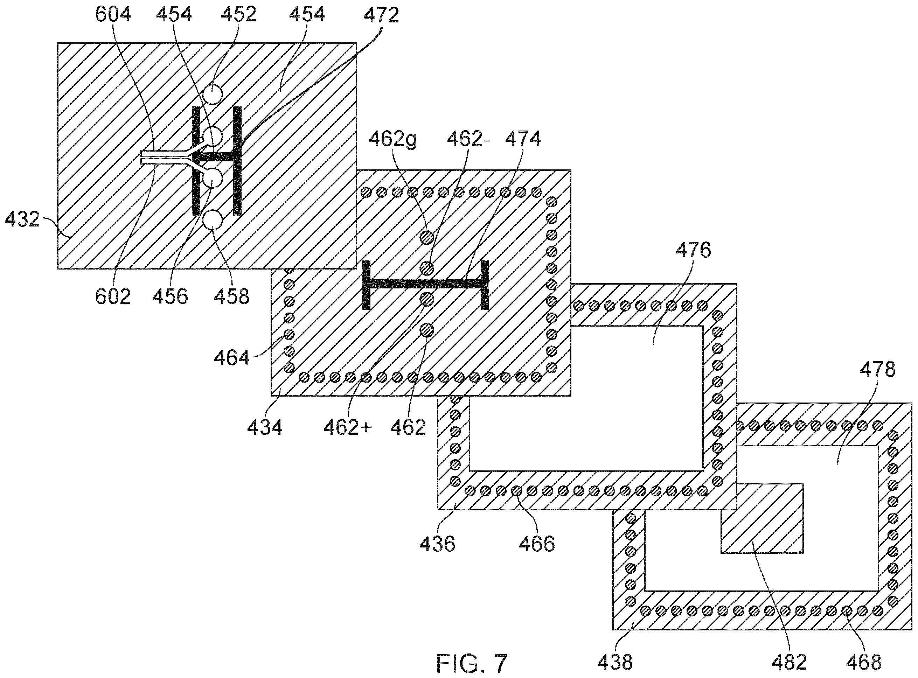

FIG. 6 shows metal layers, openings and vias of the embodiments illustrated in FIG. 4 in more detail, and FIG. 7 shows an exploded view of the layers. The FIG. s show a pair of tracks 602 and 604 for routing a signal within or along the surface of the semiconductor die (not shown) to a pair of pillars or bumps 454 and 456, which are generally aligned with and are between a pair of ground or earthed pillars 452 and 458. The pair of pillars 454 and 456 are for transferring the differential signal S+ and S- to the metal layer M1 432. Between the pair of pillars 454 and 456 is a slot opening at 472 through the metal layer M1 432. The slot opening is arranged and configured to be a resonant slot. Thus the exact length of the slot will depend on the detailed design, but is generally of the order of ½.λm, where λm is the wavelength of the signal in the medium (which is typically a dielectric material or air). For efficient low loss transition, the resonant slot may be arranged in an H configuration as shown, in which the resonant slot 472 forms the crossbar of an "H" shape.

Not visible in FIG. 6, but shown in the exploded view of FIG. 7 on the metal layer M2 434 are vias 462g, 462-, 462+ and 462 in positions vertically aligned the pillars or bumps 452, 454, 456 and 458, providing electrical (galvanic) connectivity to the metal layer M2 434. Metal layer M2 434 has an opening therethrough. In embodiments such as that shown in FIG. 6 and FIG. 7, the opening through metal layer M2 434 takes the form of a further resonant slot 474. Similar to the resonant slot 472, the resonant slot 474 may be the crossbar of a further "H" shaped opening, and the size of both the crossbar and legs of the "H" shape will depend on the detailed design, including factors such as the vertical separation of the metal layers M1 and M2, and M2 and M3, but in general the length of the crossbar will be of the order of ½.λm.

FIG. 7 also shows electrically conductive vias 464 arranged in a generally rectangular pattern on the metal layer M2 434. The pattern of electrically conductive vias 464 is generally rectangular in that it consists of four lines of vias, arranged in a rectangle. The vias located towards the corners of the rectangle may be displaced somewhat to provide rounded corners. The vias provide an electrically conductive path, through the dielectric material (not shown), between metal layer M2 434 and metal layer M1 432.

As can be seen in FIG. 7, a further generally rectangular pattern of electrically conductive vias 466 is arranged on the metal layer M3 436. This pattern of vias is positioned so as to be vertically aligned with the pattern of electrically conductive vias 464 on metal layer M2 434, and provides an electrically conductive path, through the dielectric material (not shown), between metal layer M3 436 and metal layer M2 434. Metal layer M3 436 has an opening 476 therethrough. The opening 476 is located within the rectangle defined by the electrically conductive vias 464, and positioned such that the resonant slots 472 and 474 in metal layers M1 432 and M2 434 respectively are, laterally, central with respect to the opening 476.

As can also be seen in FIG. 7, a yet further, generally rectangular, pattern of electrically conductive vias 468 is arranged on the metal layer M4 438, also arranged so as to be vertically aligned with the electrically conductive vias 466 on metal layer M3 436, and providing an electrically conductive path, through dielectric material, between metal layer M4 438 and metal layer M3 436. Metal layer M4 438 also has an opening 478 therethrough, within the rectangle defined by the electrically conductive vias 468, and arranged such that the resonant slots 472 and 474 are, laterally, central with respect to the opening 478. The opening 476 in metal layer M3 436 may be the same size as the opening 478 in metal layer M4 438, as shown in FIG. 7, or may be smaller in one or both of its length and width dimensions.

As has already been mentioned, the metal layer M4 438 includes a patch or plate 482 within the opening 478. The patch of plate 482 is generally centrally positioned within the opening, and operates as a patch antenna in the transitioning of the propagation mode of a signal from a differential transmission mode to a waveguide transmission mode.

It will be appreciated that although FIG. 6 appears to show a definite boundary to the metal layers, and the exploded view shown in FIG. 7 includes metal layers having a well-defined edge, in practical embodiments the metal layers extend across other parts of the substrate. The metal layers may be further patterned, for example in order to provide suitable conduction paths for ground or low frequency signals or to provide further differential mode to waveguide propagation mode.

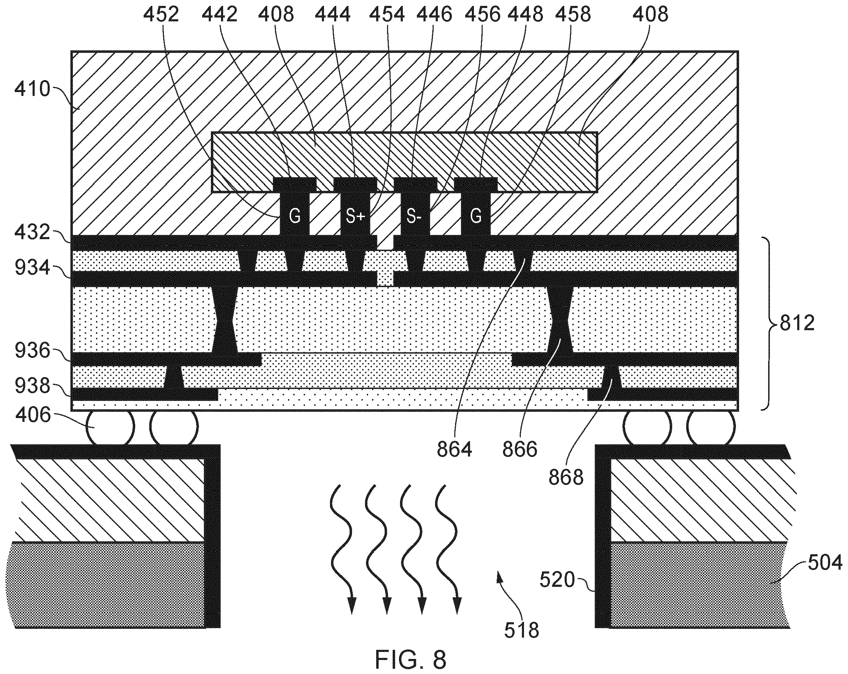

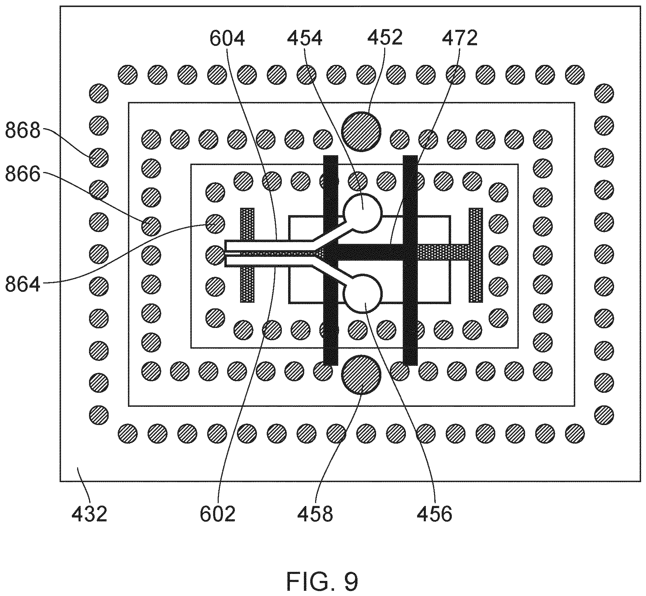

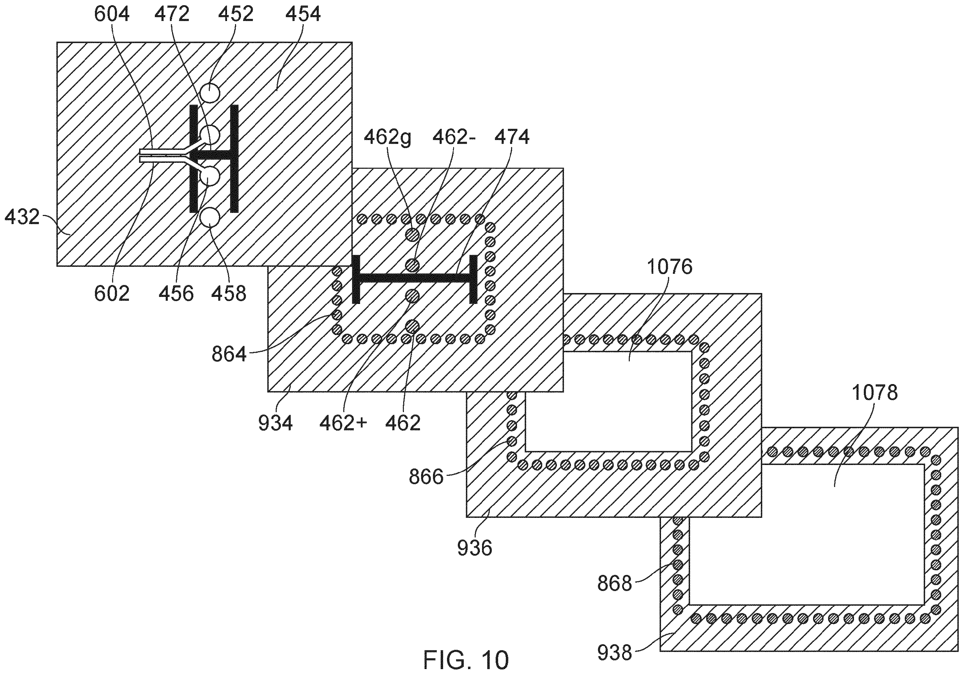

FIG. 8 shows an assembly comprising a packaged semiconductor device mounted on a support such as a printed circuit board PCB 504 according to one or more other embodiments than that shown in FIG. 5. The PCB 504, solder balls 406 of the ball grid array are the same as that shown in FIG. 5. Furthermore, the MMIC comprising the semiconductor die encapsulated in an encapsulant 410, contact pads 442, 444, 446 and 448, and the pillars or bumps 452, 454, 456 and 458 may be the same as that shown in FIG. 4 and FIG. 5. However, in the embodiment shown in FIG. 8, the metal layers within the multilayer laminate substrate 812 are configured and arranged differently to those in multilayer laminate substrate 412. The arrangements of the metal layers, and in particular the openings therein and the via therebetween according to embodiments such as that shown in FIG. 8 will now be described having regards to FIG. 9 and FIG. 10.

FIG. 9 shows metal layers, openings, and vias of the embodiments illustrated in FIG. 8 in more detail, and FIG. 10 shows an exploded view of the layers. Similar to the embodiments illustrated in FIG. 6 and FIG. 7, FIG. 9 and FIG. 10 show a pair of tracks 602 and 604 for routing a signal within or along the surface of the semiconductor die (not shown) to a pair of pillars or bumps 454 and 456, which are aligned with and between a pair of ground or earthed pillars 452 and 458. The pair of pillars 454 and 456 are for transferring the differential signal S+ and S- to the metal one layer M1 432. Between the pair of pillars 454 and 456 is a slot opening at 472 through the metal layer M1 432. The slot opening is arranged and configured to be a resonant slot.

Also similar to the embodiments illustrated in FIG. 6 and FIG. 7, and not visible in FIG. 9, but shown in the exploded view of FIG. 10, on the metal layer M2 434 are vias 462g, 462-, 462+ and 462 in positions vertically aligned with the pillars or bumps 452, 454, 456 and 458, providing electrical (galvanic) connectivity to the metal layer M2 434. Metal layer M2 434 has an opening therethrough. In embodiments such as that shown in FIG. 9 and FIG. 10, the opening through metal layer M2 434 takes the form of a further resonant slot 474. Similar to the resonant slot 472, the resonant slot 474 may be the crossbar of a further "H" shaped opening.

FIG.9 and FIG. 10 also shows electrically conductive vias 864 arranged in a generally rectangular pattern on the metal layer M2 934. The pattern of electrically conductive vias 864 forms a via fence. As shown, the pattern may be generally rectangular in that it consists of four lines of vias arranged in a rectangle. The vias located towards the corners of the rectangle may be displaced somewhat to provide rounded corners. The vias provide an electrically conductive path, through dielectric material (not shown), between metal layer M2 934 and metal layer M1 432. Compared with the embodiments shown in FIG. 7, the rectangular pattern of electrically conductive vias 864 is smaller than the rectangular pattern of electrically conductive vias 464.

As can be seen in FIG. 9 and FIG. 10, a further generally rectangular pattern of electrically conductive vias 866 is arranged on the metal layer M3 936. These vias provide an electrically conductive path, through dielectric material (not shown), between metal layer M3 936 and metal layer M2 934. The rectangle defined by the pattern of electrically conductive vias 866 is larger than the rectangle defined by the pattern of electrically conductive vias 864 in metal layer M2 934. Metal layer M3 936 has an opening 1076 therethrough. The opening 1076 is located centrally within the rectangle defined by the electrically conductive vias 866, and positioned such that the resonant slots 472 and 474 in metal layers M1 432 and M2 934 respectively are, laterally, central with respect to the opening 1076.

As can also be seen in FIG. 9 and FIG. 10, a yet further, generally rectangular, pattern of electrically conductive vias 868 is arranged on the metal layer M4 938, providing an electrically conductive path, through dielectric material, between metal layer M4 938 and metal layer M3 936. The rectangle defined by the pattern of electrically conductive vias 868 is larger than the rectangle defined by the pattern of electrically conductive vias 866 in metal layer M3 936. Metal layer M4 438 also has an opening 1078 therethrough, within the rectangle defined by the electrically conductive vias 868, and arranged such that the resonant slots 472 and 474 are, laterally, central with respect to the opening 478. The opening 1076 in metal layer M3 936 is smaller than opening 1078 in metal layer M4 938, as shown in FIG. 7, in one or both of its length and width dimensions, as shown in FIG. 9.

An effect of the arrangement of the fences of vias in the metal layers M2 934, M3 936 and M4 938 is to provide a tapered waveguide opening such that an effective size of the aperture, and the actual size of the openings 1076 and 1078 in metal layers M3 936 and M4 938 respectively, increases from the MMIC towards the bottom surface of the multilayer laminate substrate 812 or metal layer M4 938. This may enhance the propagation of the TE10 mode, by coupling the field to the waveguide opening at the bottom surface of the multilayer laminate substrate 812 or metal layer M4 938.

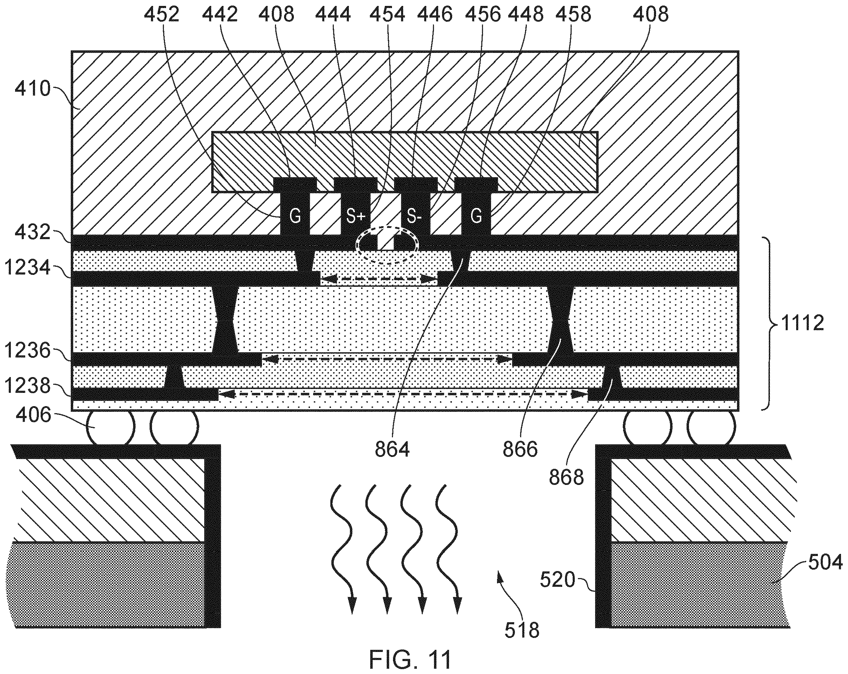

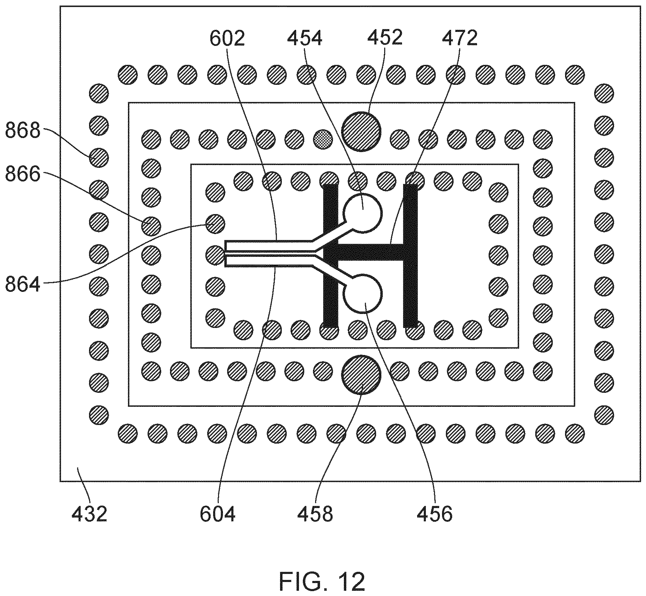

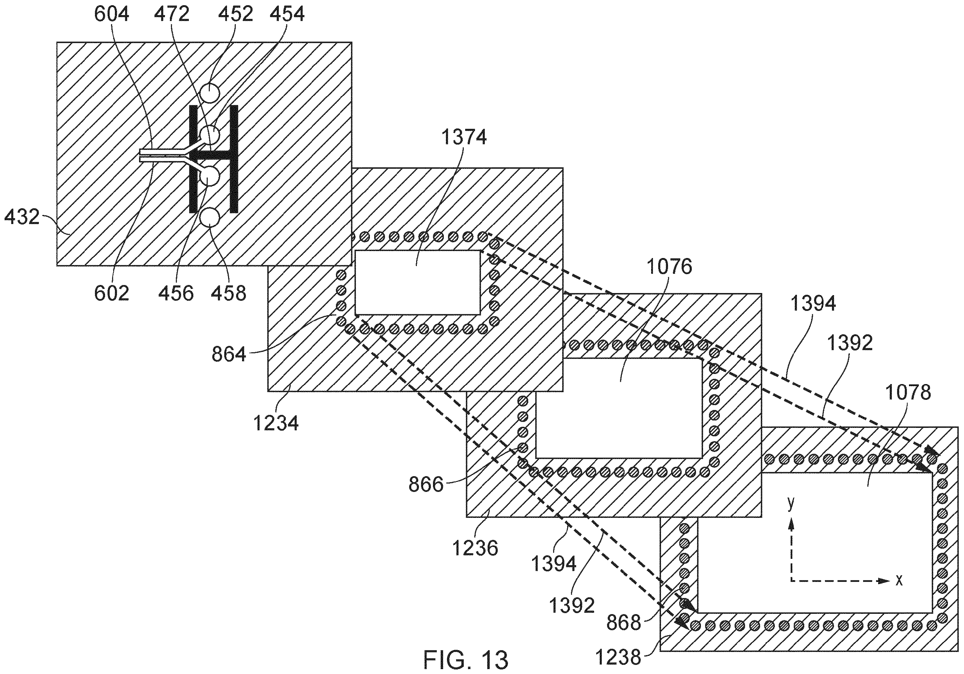

Turning now to FIG. 11, FIG. 11 shows an assembly comprising a packaged semiconductor device mounted on a support such as a printed circuit board PCB 504 according to one or more other embodiments. The PCB 504, solder balls 406 of the ball grid array are the same as that shown in FIG. 5. Furthermore, the MMIC comprising the semiconductor die encapsulated in an encapsulant 410, contact pads 442, 444, 446, 448, and the pillars or bumps 452, 454, 456 and 458 may be the same as that shown in FIG. 4 and FIG. 5. However, in the embodiment shown in FIG. 11, the metal layers within the multilayer laminate substrate 1112 are configured and arranged differently to those in multilayer laminate substrate 412. The arrangements of the metal layers, and in particular the openings therein and the via therebetween according to embodiments such as that shown in FIG. 11 will now be described having regards to FIG. 12 and FIG. 13.

FIG. 12 shows metal layers, openings, and vias of the embodiments illustrated in FIG. 11 in more detail, and FIG. 13 shows an exploded view of the layers. Similar to the embodiments illustrated in FIG. 6 and FIG. 7, FIG. 12 and FIG. 13 show a pair of tracks 602 and 604 for routing a signal within or along the surface of the semiconductor die (not shown) to a pair of pillars or bumps 454 and 456, which are aligned with and between a pair of ground or earthed pillars 452 and 458. The pair of pillars 454 and 456 are for transferring the differential signal S+ and S- to the metal one layer M1 432. Between the pair of pillars 454 and 456 is a slot opening at 472 through the metal layer M1 432. The slot opening is arranged and configured to be a resonant slot.

Metal layer M2 1234 has an opening 1374 therethrough. In embodiments such as that shown in FIG. 12 and FIG. 13, the opening 1374 through metal layer M2 1234 is a rectangle. FIG. 12 and FIG. 13 also shows electrically conductive vias 864 arranged in a generally rectangular pattern on the metal layer M2 1234 around the opening 1374. The pattern of electrically conductive vias 864 is generally rectangular in that it consists of four lines of vias arranged in a rectangle. The vias located towards the corners of the rectangle may be displaced somewhat to provide rounded corners. The vias provide an electrically conductive path, through dielectric material (not shown), between metal layer M2 1234 and metal layer M1 432. Compared with the embodiments shown in FIG. 7, the rectangular pattern of electrically conductive vias 864 is smaller than the rectangular pattern of electrically conductive vias 464.

As can be seen in FIG. 12 and FIG. 13, a further generally rectangular pattern of electrically conductive vias 866 is arranged on the metal layer M3 936. These vias provide an electrically conductive path, through dielectric material (not shown), between metal layer M3 936 and metal layer M2 1234. The rectangle defined by the pattern of electrically conductive vias 866 is larger than the rectangle defined by the pattern of electrically conductive vias 864 in metal layer M2 934. Metal layer M3 936 has an opening 1076 therethrough. The opening 1076 is located centrally within the rectangle defined by the vias 866, and positioned such that the resonant slot 472 in metal layer M1 432 is, laterally, central with respect to the opening 1076.

As can also be seen in FIG. 12 and FIG. 13, a yet further, generally rectangular, pattern of electrically conductive vias 868 is arranged on the metal layer M4 938, providing an electrically conductive path, through dielectric material, between metal layer M4 938 and metal layer M3 936. The rectangle defined by the pattern of electrically conductive vias 868 is larger than the rectangle defined by the pattern of electrically conductive vias 866 in metal layer M3 936. Metal layer M4 438 also has an opening 1078 therethrough, within the rectangle defined by the electrically conductive vias 868, and arranged such that the resonant slot 472 is, laterally, central with respect to the opening 478. The opening 1076 in metal layer M3 936 is smaller than opening 1078 in metal layer M4 938, as shown in FIG. 7, in one or both of its length and width dimensions, as shown in FIG. 13.

As shown by the dashed lines 1392 and 1394, both the apertures or openings 1374, 1076 and 1078 in the metal layers M2, M3, and M4 respectively, and the rectangles of shielding or fencing vias 864, 866 and 868 between the metal layers increase in size through the substrate. This may provide an effective tapered waveguide opening configuration in order to assist in providing a low loss transition to the waveguide mode. In one or more embodiments, both the length (in the x direction illustrated) and the width (in in the y direction illustrated) of the apertures and rectangles increases between metal layer M2 1234 and metal layer M4 1238. In other embodiments the links (being the larger dimension, in the x direction as illustrated) is the same or substantially the same in the metal layers M2 1234, M3 1236 and M4 1238, whereas the width (being the smaller dimension, in the Y direction as illustrated) increases from metal layer M2 1234 to M4 1238.

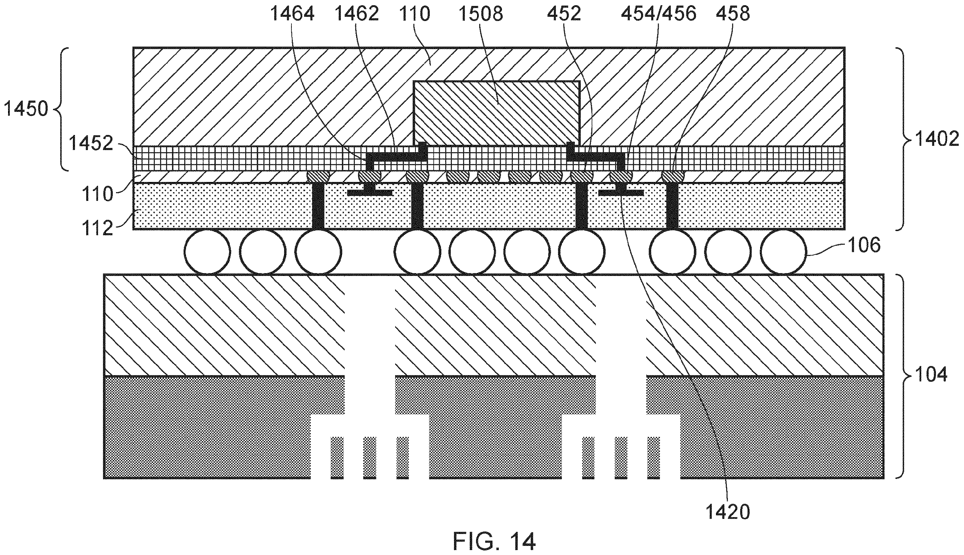

FIG. 14 shows an assembly comprising a packaged semiconductor device mounted on a support such as a printed circuit board PCB 504 according to one or more other embodiments than that shown in FIG. 5. The PCB 504, and solder balls 406 of the ball grid array are the same as that shown in FIG. 5. Furthermore, the pillars or bumps 452, 454, 456 and 458 may be the same as that shown in FIG. 4 and FIG. 5, and the substrate may have any of the configurations described above and relating to embodiments illustrated in FIG. 4 through FIG. 13, so as to provide a "launcher in package" having a direct propagation mode transition from differential strip-line to fundamental mode of wave propagation. This is illustrated in FIG. 14 schematically by the "patch antenna" shown at 1420.

However, in the embodiment shown in FIG. 14, the MMIC device 1450 comprises a so-called fanout laminate 1452 in addition to a semiconductor die 1508. The fanout laminate may include redistribution layer (RDL) functionality, so as to more widely space apart pillars or bumps 452, 454, etc. at the external surface of the MMIC device, that may be the semiconductor die contacts pads. The RDL is illustrated schematically by tracks 1462 and vias 1464. Such a fanout laminate may be particularly useful for MMICs having a high resolution die pad pitch. In these embodiments the RDL is carried out using pairs of signal lines to enable fully differential signal propagation within the fanout laminate. Thus, whereas for ease of understanding only a single signal-transfer bump or pillar "454/456" is visible for each launcher, in practical embodiments, there will be a pair of bumps of pillars carrying S+ and S- respectively. Conceptually, in this figure one bump (e.g. 456), may be considered to be "behind" the other bump (e.g. 454), and thus not visible in the schematic section. It will be appreciated that in embodiments such as that shown in FIG. 14, the plurality of pillars (452, 454, 456, 458) which connect the package substrate to the MMIC device are between the fanout laminate and the first metal layer, where in embodiments such as that shown in FIG. 14, the plurality of pillars (452, 455, 456, 458) which connect the package substrate to the MMIC device are directly connected to the semiconductor die itself.

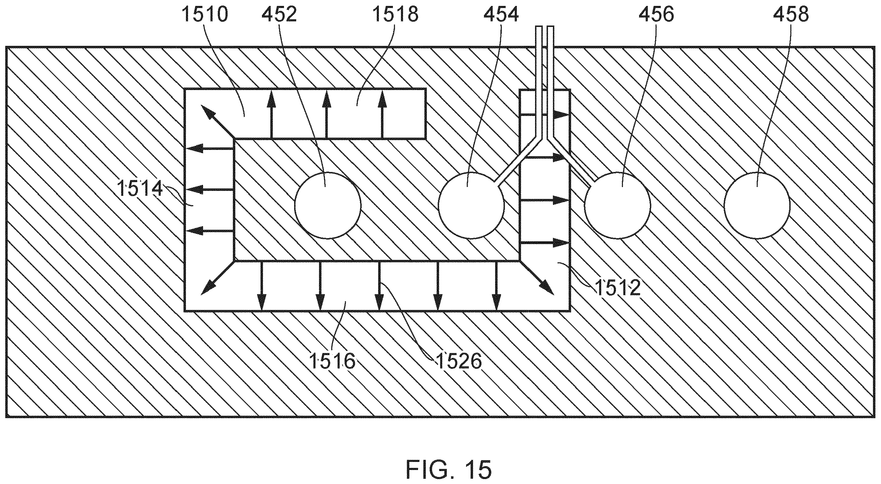

Turning now to FIG. 15, this shows an alternative configuration of a resonant slot in one or both of the first metal layer M1 432 and second metal layer M2 434. In this configuration, the resonant slot 1512 positioned between the bumps or pillars 454 and 456 forms one section of a multi-section opening 1510. Resonant slot section 1512 forms the first arm of a re-entrant meandering slot. One end of the resonant slot section 1512 is connected to a first end of a third arm 1514 of the re-entrant meandering slot, oriented antiparallel with section 1512 by means of a second arm 1516, which is orthogonal to the resonant slot section and the third arm. A fourth arm 1518 of the re-entrant meandering slot is connected to the other end of the third arm, and is anti-parallel to the second arm, that is to say it extends back towards the resonant slot section. As shown the re-entrant meandering slot partially enclose not only the bump or pillar 454, but also a second bump or pillar 452 which forms one of a pair of grounding bumps and pillars 452 and 458. As is described in more detail in patent application EP 2338 61 31.9, filed at the European patent office on 7 December 2023, the entire contents of which are incorporated herein by reference, such a configuration may be beneficial in at least partially cancelling E fields 1526 orthogonal to the resonant slot direction.

Aspects of this disclosure may readily lend themselves to conventional circuit, device, and PCB manufacturing/fabrication techniques. For example, aspects of this disclosure may be implemented with little-to-no additional cost (in terms of, e.g., package development or innovation) or energy consumption/power dissipation relative to conventional techniques, while at the same time providing additional benefits in terms of achieving/realizing isolation. In this respect, aspects of this disclosure represent substantial improvements relative to conventional technologies in terms of practical applications involving circuit design and assembly/fabrication/manufacture. In brief, and as demonstrated herein, the various aspects of this disclosure are not directed to abstract ideas. To the contrary, the various aspects of this disclosure are directed to, and encompass, significantly more than any abstract idea standing alone.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A packaged semiconductor device, comprising:
a monolithic microwave integrated circuit, MMIC, device comprising a semiconductor die and having a differential IO being a one of a differential input and a differential output; and
a package substrate comprising dielectric between each of at least a first metal layer, a second metal layer, a third metal layer (M3) and a fourth metal layer, and electrically conductive vias between the metal layers;
wherein the package substrate is connected to the MMIC device by a plurality of pillars between the MMIC device and the first metal layer, the plurality of pillars including a pair of the pillars which connect the differential IO to the first metal layer;
wherein the first metal layer comprises a resonant slot opening therethrough between the pair of pillars; and
wherein the second metal layer, third metal layer and the fourth metal layer each comprise an opening therethrough,
wherein the resonant slot opening and the respective openings in the second, third and fourth metal layers are configured to transition the IO signal between a differential mode and a waveguide fundamental mode of propagation at the fourth metal layer.

2. The packaged semiconductor device of claim 1,
wherein the resonant slot opening comprises a cross-bar of an H-shaped slot opening.

3. The packaged semiconductor device of claim 1,
wherein the vias between each metal layer are arranged in a respective rectangle.

4. The packaged semiconductor device of any preceding claim,
wherein the fourth metal layer is a farthest metal layer of the package substrate from the MMIC device, and the opening therethrough is sized to match for transverse electric 10, TE10, waveguide propagation of the signal.

5. The packaged semiconductor device of any preceding claim,
wherein the opening through the second metal layer comprises a second resonant slot opening.

6. The packaged semiconductor device of claim 5,
wherein the second resonant slot opening comprises a cross-bar of an H-shaped slot opening.

7. The packaged semiconductor device of claim 5 or 6,
wherein the fourth metal layer comprises a metal patch within the opening therethrough.

8. The packaged semiconductor device of any of claims 5 to 7,
wherein the third metal layer is arranged between the second metal layer and the fourth metal layer, and has an opening therethrough having the same dimensions as the opening through the fourth layer.

9. The packaged semiconductor device of any of claims 5 to 8,
wherein the vias between each of the metal layers are aligned around a same perimeter of the opening through the fourth metal layer.

10. The packaged semiconductor device of any of claims 1 to 4,
wherein the rectangle of vias between the first and second metal layers has a shorter side which is shorter than the corresponding shorter side of the rectangle of vias connecting between the second and third metal layer, and the shorter side of the rectangle of vias between the second and third metal layers is shorter than the corresponding shorter side of the rectangle of vias connecting between the third and fourth metal layers.

11. The packaged semiconductor device of claim 10,
wherein the second metal layer has a rectangular opening (1374) therethrough.

12. The packaged semiconductor device of claim 11,
wherein the rectangular opening through the second metal layer is smaller than the opening through the third metal layer.

13. The packaged semiconductor device of any preceding claim,
wherein the MMIC device further comprises encapsulant which at least partially encapsulates the semiconductor die, and
wherein the differential IO comprises contact pads on the semiconductor die.

14. The packaged semiconductor device of any of claims 1 to 12,
wherein the MMIC device further comprises a fanout laminate, on which the semiconductor die is mounted and which is configured to provide a fanout contact pattern, and
wherein the differential IO comprises pads on the fanout laminate, which pads are more spaced apart than corresponding contact pads on the semiconductor die, and connected thereto by a pair of strip lines configured to carry a signal in the differential mode to the differential IO.

15. The packaged semiconductor device of any preceding claim, wherein the packaged semiconductor device is a ball grid array, BGA, packaged semiconductor device.

## Amended claims

### Amended claims in accordance with Rule 137(2) EPC.

1. A packaged semiconductor device (300), comprising:
a monolithic microwave integrated circuit, MMIC, device comprising a semiconductor die (308) and having a differential IO being a one of a differential input and a differential output; and
a package substrate comprising dielectric (460) between each of at least a first metal layer (432), a second metal layer (434), a third metal layer (436, M3) and a fourth metal layer (438), and electrically conductive vias between the metal layers;
wherein the package substrate is connected to the MMIC device by a plurality of pillars (452, 454, 456, 458) between the MMIC device and the first metal layer, the plurality of pillars including a pair (454, 456) of the pillars which connect the differential IO to the first metal layer;
wherein the first metal layer comprises a resonant slot (472) opening therethrough between the pair of pillars; and
wherein the second metal layer, third metal layer and the fourth metal layer each comprise an opening (474, 475, 478) therethrough,
wherein the resonant slot opening and the respective openings in the second, third and fourth metal layers are configured to transition the IO signal between a differential mode and a waveguide fundamental mode of propagation at the fourth metal layer.

2. The packaged semiconductor device of claim 1,
wherein the resonant slot opening comprises a cross-bar of an H-shaped slot opening.

3. The packaged semiconductor device of claim 1,
wherein the vias between each metal layer are arranged in a respective rectangle.

4. The packaged semiconductor device of any preceding claim,
wherein the fourth metal layer is a farthest metal layer of the package substrate from the MMIC device, and the opening therethrough is sized to match for transverse electric 10, TE10, waveguide propagation of the signal.

5. The packaged semiconductor device of any preceding claim,
wherein the opening through the second metal layer comprises a second resonant slot opening.

6. The packaged semiconductor device of claim 5,
wherein the second resonant slot opening comprises a cross-bar of an H-shaped slot opening.

7. The packaged semiconductor device of claim 5 or 6,
wherein the fourth metal layer comprises a metal patch (482) within the opening therethrough.

8. The packaged semiconductor device of any of claims 5 to 7,
wherein the third metal layer is arranged between the second metal layer and the fourth metal layer, and has an opening therethrough having the same dimensions as the opening through the fourth layer.

9. The packaged semiconductor device of any of claims 5 to 8,
wherein the vias between each of the metal layers are aligned around a same perimeter of the opening through the fourth metal layer.

10. The packaged semiconductor device of any of claims 1 to 4,
wherein the rectangle of vias between the first and second metal layers has a shorter side which is shorter than the corresponding shorter side of the rectangle of vias connecting between the second and third metal layer, and the shorter side of the rectangle of vias between the second and third metal layers is shorter than the corresponding shorter side of the rectangle of vias connecting between the third and fourth metal layers.

11. The packaged semiconductor device of claim 10,
wherein the second metal layer has a rectangular opening (1374) therethrough.

12. The packaged semiconductor device of claim 11,
wherein the rectangular opening through the second metal layer is smaller than the opening through the third metal layer.

13. The packaged semiconductor device of any preceding claim,
wherein the MMIC device further comprises encapsulant (110) which at least partially encapsulates the semiconductor die, and
wherein the differential IO comprises contact pads on the semiconductor die.

14. The packaged semiconductor device of any of claims 1 to 12,
wherein the MMIC device further comprises a fanout laminate (1452), on which the semiconductor die is mounted and which is configured to provide a fanout contact pattern, and
wherein the differential IO comprises pads on the fanout laminate, which pads are more spaced apart than corresponding contact pads on the semiconductor die, and connected thereto by a pair of strip lines (1462) configured to carry a signal in the differential mode to the differential IO.

15. The packaged semiconductor device of any preceding claim, wherein the packaged semiconductor device is a ball grid array, BGA, packaged semiconductor device.
